# EUROPÄISCHE PATENTSCHRIFT

(11) **EP 3 919 925 B1**
(45) Veröffentlichungstag und Bekanntmachung des Hinweises auf die Patenterteilung: **10.07.2024**
(21) Anmeldenummer: 21170576.9
(22) Anmeldetag: 27.04.2021
(51) Int. Cl.: G01R 31/367, G01R 31/392, H01M 10/44, H01M 10/42, H01M 10/48, B60L 58/16

(54) **KOSTENGÜNSTIGE UND DENNOCH GENAUE ERMITTLUNG DES DEGRADATIONSZUSTANDES EINER WIEDERAUFLADBAREN BATTERIE**
COST-EFFECTIVE AND PRECISE DETERMINATION OF THE DEGRADATION OF A RECHARGEABLE BATTERY
DÉTERMINATION ÉCONOMIQUE ET TOUJOURS PRÉCISE DE L'ÉTAT DE DÉGRADATION D'UNE BATTERIE RECHARGEABLE

(30) Priorität: 03.06.2020 DE 102020206915
(43) Veröffentlichungstag der Anmeldung: 08.12.2021
(73) Patentinhaber: Robert Bosch GmbH, 70442 Stuttgart (DE)
(72) Erfinder: Simonis, Christian, 71229 Leonberg (DE); Woll, Christoph, 70839 Gerlingen (DE); Kupcsik, Andras Gabor, 71034 Boeblingen (DE)

(56) Entgegenhaltungen:
- PIAO CHANGHAO ET AL: "Analysis of Real-Time Estimation Method Based on Hidden Markov Models for Battery System States of Health", JOURNAL OF POWER ELECTRONICS, vol. 16, no. 1, 20 January 2016 (2016-01-20), pages 217 - 226, XP055853846, ISSN: 1598-2092, Retrieved from the Internet <URL:https://www.koreascience.or.kr/article/JAKO201611366529677.pdf> DOI: 10.6113/JPE.2016.16.1.217
- LIN YUN ET AL: "Evaluation of Lithium Batteries Based on Continuous Hidden Markov Model", 2017 IEEE INTERNATIONAL CONFERENCE ON SOFTWARE QUALITY, RELIABILITY AND SECURITY COMPANION (QRS-C), IEEE, 25 July 2017 (2017-07-25), pages 221 - 225, XP033139481, DOI: 10.1109/QRS-C.2017.43
- LEE CHANGYONG ET AL: "Capacity-Fading Behavior Analysis for Early Detection of Unhealthy Li-Ion Batteries", IEEE TRANSACTIONS ON INDUSTRIAL ELECTRONICS, IEEE SERVICE CENTER, PISCATAWAY, NJ, USA, vol. 68, no. 3, 13 February 2020 (2020-02-13), pages 2659 - 2666, XP011821816, ISSN: 0278-0046, [retrieved on 20201125], DOI: 10.1109/TIE.2020.2972468

## Beschreibung

Die vorliegende Erfindung betrifft die Überwachung und Vorhersage des Degradationszustandes wiederaufladbarer Batterien, insbesondere für zumindest teilweise elektrisch angetriebene Fahrzeuge.

### Stand der Technik

Wiederaufladbare Batterien wandeln beim Laden elektrische Energie aus einer externen Versorgung in chemische Energie um. Beim Entladen wird die chemische Energie umgekehrt in elektrische Energie umgewandelt, die einen externen Verbraucher speist. Insbesondere bei Traktionsbatterien in zumindest teilweise elektrisch angetriebenen Fahrzeugen, wie rein batterieelektrischen Fahrzeugen oder Hybridfahrzeugen, wird regelmäßig ein nennenswerter Anteil der gespeicherten Energie entnommen, und dieser Anteil wird später wieder geladen.

Derzeitige elektrochemische Batterien unterliegen einem Degradationsprozess. Mit zunehmender Betriebsdauer, und insbesondere mit zunehmender Anzahl absolvierter Lade- und Entladezyklen, sinkt die nutzbare Kapazität. Dabei hängt dieser Alterungsprozess unter anderem vom Nutzungsprofil und von den Betriebsbedingungen ab. So ist es beispielsweise bekannt, dass akkubetriebene Smartphones in den Händen mancher Nutzer über viele Jahre gute Dienste leisten, während sich in den Händen anderer Nutzer der Akku als das Verschleißteil erweist, das als erstes versagt.

Aus der EP 2 852 848 B1 ist ein Verfahren zur Bestimmung kinetischer Parameter eines Modells einer Batterie bekannt. Auf der Basis dieses Modells kann ein Degradationszustand, SOH (State Of Health), ermittelt werden.

Weitere relevante Dokumente sind PIAO CHANGHAO ET AL: "Analysis of Real-Time Estimation Method Based on Hidden Markov Models for Battery System States of Health",JOURNAL OF POWER ELECTRONICS,Bd. 16, Nr. 1 20. Januar 2016 (2016-01-20), Seiten 217-226, XP055853846,ISSN: 1598-2092, DOI: 10.6113/ JPE.2016.16.1.217; LIN YUN ETAL: "Evaluation of Lithium Batteries Based on Continuous Hidden Markov Model",2017 IEEE INTERNATIONAL CONFERENCE ON SOFTWARE QUALITY, RELIABILITY AND SECURITY COMPANION (QRS-C), IEEE, 25. Juli 2017 (2017-07-25), Seiten 221-225, XP033139481,DOI: 10.1109/QRS-C.2017.43; und LEE CHANGYONG ET AL: "Capacity-Fading Behavior Analysis for Early Detection of Unhealthy Li-Ion Batteries",IEEE TRANSACTIONS ON INDUSTRIAL ELECTRONICS, IEEE SERVICE CENTER, PISCATAWAY, NJ, USA, Bd. 68, Nr. 3, 13. Februar 2020 (2020-02-13), Seiten 2659-2666, XP011821816,ISSN: 0278-0046, DOI: 10.1109/ TIE.2020.2972468.

### Offenbarung der Erfindung

Im Rahmen der Erfindung wurde ein Verfahren zur Ermittlung einer Näherung und/oder Prognose für den wahren Degradationszustand einer wiederaufladbaren Batterie gemäß Anspruch 1 entwickelt.

Bei diesem Verfahren wird eine in vorgegebenen Zeitschritten diskretisierte Zeitreihe von für Zeitpunkte in der Vergangenheit messtechnisch ermittelten Werten des Degradationszustandes bereitgestellt.

Hierbei ist unter "messtechnischem Ermitteln" jedes Erfassen von Messwerten mit einer anschließenden Auswertung, die ein Maß für den Degradationszustand liefert, zu verstehen. Der Degradationszustand lässt sich in vielerlei Weise näherungsweise bestimmen. Ein Sensor, der direkt den Wert des Degradationszustandes liefert, ist also nicht erforderlich.

So können beispielsweise die beobachteten Werte des Degradationszustandes anhand einer Ladungsmenge ermittelt werden, die beim Aufladen der Batterie von einer ersten Klemmenspannung auf eine zweite, höhere Klemmenspannung in die Batterie abgegeben wird. Typische Batteriezellen für Traktionsbatterien von Fahrzeugen können beispielsweise ausgehend von einer Klemmenspannung von 3 V auf ihre Ladeschlussspannung von 4,2 V aufgeladen werden. Es kann dann mittels "Coulomb-Counting", etwa durch Integration des in die Batterie fließenden Stroms, die in die Batterie abgegebene Ladungsmenge ermittelt werden. Je mehr Ladung die Batterie aufnehmen kann, desto größer ist ihre noch nutzbare Kapazität, und desto besser ist ihr Degradationszustand.

Die beobachteten Werte des Degradationszustandes werden anhand einer Zeitdauer ermittelt, in der die Klemmenspannung der Batterie unter Belastung mit einer vorgegebenen Last von einem ersten Wert auf einen zweiten, niedrigeren Wert absinkt. Je länger die Klemmenspannung oberhalb des zweiten, niedrigeren Werts bleibt, desto größer ist die Kapazität, aus der sie die Last speist, und desto besser ist ihr Degradationszustand.

Es werden während des Entladens der Batterie Zeitreihen der Klemmenspannung, des Entladestroms sowie des Ladezustandes der Batterie erfasst. Die beobachteten Werte des Degradationszustandes werden dann anhand eines physikalischen Modells des Degradationszustandes aus diesen Zeitreihen ermittelt. Hierbei wird noch zusätzlich eine Temperatur in der Batterie während des Entladens erfasst und diese Temperatur wird in dem physikalischen Modell berücksichtigt. Die genannten Größen stehen insbesondere an Bord eines zumindest teilweise elektrisch angetriebenen Fahrzeugs regelmäßig zur Verfügung.

Die hier exemplarisch genannten Methoden, so wie auch alle anderen Methoden zur näherungsweisen Bestimmung des Degradationszustandes, sind hinsichtlich der Genauigkeit der ermittelten Näherung durch die Genauigkeit limitiert, mit denen die jeweils genutzten Messwerte erfasst werden können. Gerade die an Bord von Fahrzeugen verbauten Messinstrumente sind jedoch typischerweise eher für eine kurzfristige Überwachung des Betriebszustandes des elektrischen Systems von Moment zu Moment ausgelegt als für eine langfristige Überwachung des Degradationszustandes. Für letzteren Zweck sind die Messdaten also mitunter vergleichsweise unsicher und verrauscht. Der Einsatz höherwertiger Messinstrumente ist teuer und garantiert dennoch keine beliebige Steigerung der Genauigkeit, da es im elektrischen System eines Fahrzeugs auf engem Raum eine Vielzahl von Störquellen für Messungen gibt.

Daher ist im Rahmen des Verfahrens vorgesehen, die Genauigkeit mit Hilfe eines trainierten Hidden Markov-Modells, HMM, zu verbessern. Ein HMM ermöglicht Wahrscheinlichkeitsaussagen über nicht direkt messbare, "versteckte" (hidden) Variablen auf der Basis von Beobachtungen, deren Wahrscheinlichkeiten von den Zuständen dieser "versteckten" Variablen abhängen. In der vorliegenden Anwendung ist die "versteckte" Variable, über die eine Aussage gewonnen werden soll, der wahre Degradationszustand der Batterie, und die messtechnisch ermittelten Werte des Degradationszustandes repräsentieren die Beobachtungen.

Dabei ist die Betrachtung grundsätzlich zeitdiskret in vorgegebenen Zeitschritten. Das Raster dieser Zeitschritte kann insbesondere mit dem Raster derjenigen Zeitschritte deckungsgleich sein, in dem auch die messtechnisch ermittelten Werte des Degradationszustandes diskretisiert sind. Zwingend erforderlich ist dies jedoch nicht. Auch der Degradationszustand selbst ist diskretisiert, beispielsweise in Prozentzahlen von 100 % für eine neue Batterie bis hinab zu 70 % für eine Batterie, bei der ein Austausch fällig ist.

Das trainierte HMM gibt in Abhängigkeit des wahren Degradationszustandes an, mit welcher Wahrscheinlichkeit bei der messtechnischen Ermittlung welcher Wert des Degradationszustandes beobachtet wird. Diese Wahrscheinlichkeiten können beispielsweise eine sogenannte "Beobachtungsmatrix" bilden. Je stärker vereinfachend das für die messtechnische Ermittlung verwendete physikalische Modell ist und je unsicherer die verwendeten Messwerte sind, desto mehr streuen die messtechnisch ermittelten Werte des Degradationszustandes um den wahren Degradationszustand. In der Beobachtungsmatrix kann somit insbesondere Vorwissen über das für die messtechnische Ermittlung des Degradationszustandes genutzte physikalische Modell und über die Unsicherheit der verwendeten Messwerte verkörpert sein.

Weiterhin gibt das trainierte HMM in Abhängigkeit eines jeden wahren Degradationszustandes an, mit welcher Wahrscheinlichkeit dieser wahre Degradationszustand im nächsten Zeitschritt in welchen schlechteren Degradationszustand übergeht. Alternativ oder auch in Kombination hierzu kann das trainierte HMM angeben, mit welcher Wahrscheinlichkeit der wahre Degradationszustand wie lange erhalten bleibt, beispielsweise in Form einer Verteilung. Diese Wahrscheinlichkeiten können beispielsweise eine "Übergangsmatrix" bilden. In der Übergangsmatrix kann somit die Dynamik der Degradation verkörpert sein. Weiterhin kann dort beispielsweise Vorwissen aus dem besagten Modell verkörpert sein, ebenso wie beispielsweise die Randbedingung, dass die Degradation irreversibel ist und monoton voranschreitet. Das heißt, durch gute Behandlung kann maximal der aktuelle Degradationszustand der Batterie gehalten werden, aber die Batterie wird sich von einer bereits erlittenen Degradation nicht mehr erholen.

Aus der beobachteten Zeitreihe messtechnisch ermittelter Werte des Degradationszustandes und dem HMM wird der wahrscheinlichste Verlauf des wahren Degradationszustandes in der Vergangenheit ermittelt, der mit der beobachteten Zeitreihe in Einklang steht. Aus diesem wahrscheinlichsten Verlauf wird die gesuchte Näherung ausgewertet. Alternativ oder auch in Kombination hierzu kann die Fortschreibung des besagten wahrscheinlichsten Verlaufs auch eine Prognose des Degradationszustands für die Zukunft liefern. Diese Aufgabe ist ein Stück weit vergleichbar mit der Fehlerkorrektur beim Auslesen von Datenträgern, bei dem das eine oder andere Bit "umgekippt" sein kann. Daher kann der wahrscheinlichste Verlauf des wahren Degradationszustandes insbesondere beispielsweise mit dem auch für die Fehlerkorrektur genutzten Viterbi-Algorithmus ermittelt werden.

Vor der Anwendung des HMM kann die Zeitreihe der beobachteten Werte des Degradationszustandes optional in beliebiger Weise geglättet, gefiltert oder sonst wie vorverarbeitet werden.

Es wurde erkannt, dass durch die Nutzung des HMM nicht nur der Einfluss von Ungenauigkeiten des verwendeten physikalischen Modells sowie von Unsicherheiten der Messwerte zurückgedrängt werden kann. Vielmehr liefert das Verfahren auch die Information, ob die Batterie unter ihren aktuellen Betriebsbedingungen eher gut behandelt wird und noch lange funktionieren wird oder ob sie von einem "Batterie-Quäler" benutzt wird, der sie auf Verschleiß fährt. Es kann also insbesondere beispielsweise in Antwort darauf, dass eine für einen künftigen Zeitpunkt ermittelte Prognose für den wahren Degradationszustand ein vorgegebenes Kriterium erfüllt, der Zeitraum bis zu diesem künftigen Zeitpunkt als verbleibende nutzbare Lebensdauer der Batterie gewertet werden.

Gerade bei Traktionsbatterien in Fahrzeugen gibt es viele Möglichkeiten, wie man die Degradation verlangsamen, aufhalten oder eben begünstigen kann. So tut es der Batterie beispielsweise weniger gut, wenn sie häufig tief entladen wird oder wenn ihr bei hohen Temperaturen hohe Ströme entnommen werden.

Daher kann beispielsweise innerhalb einer Flotte von elektrisch angetriebenen Fahrzeugen auch bei vergleichbaren Fahrleistungen der Degradationszustand der Batterien sehr inhomogen verteilt sein. Eine Prognose für die Zukunft ermöglicht es, den Austausch der Traktionsbatterie genau zu dem Zeitpunkt vorzunehmen, zu dem er wirklich nötig ist. Da die Traktionsbatterie das teuerste Teil an einem elektrisch angetriebenen Fahrzeug sein kann, kostet ein verfrühter Austausch viel Geld. Ein verspäteter Austausch kann hingegen dazu führen, dass das Fahrzeug liegenbleibt und teuer abgeschleppt werden muss. Derzeit ist es noch nicht vorgesehen, dass die Traktionsbatterie vor Ort durch einen Pannendienst ausgetauscht wird.

Wie zuvor erläutert, hängt die Unsicherheit des messtechnisch ermittelten Degradationszustandes der Batterie insbesondere von den Unsicherheiten der verwendeten Messwerte und von dem physikalischen Modell ab. Das physikalische Modell entscheidet über die Fortpflanzung der Einzel-Unsicherheiten der Messwerte zur Gesamt-Unsicherheit des ermittelten Degradationszustandes. Dies kann bereits beim Training des HMM für den Einsatz in dem zuvor beschriebenen Verfahren berücksichtigt werden. Daher stellt die Erfindung auch ein Verfahren zum Trainieren eines HMM für diesen Einsatz gemäß Anspruch 6 bereit.

Bei diesem Verfahren werden Zeitreihen des Verlaufs des wahren Degradationszustandes einer Vielzahl von Batterien während ihres Gebrauchs bereitgestellt. Beispielsweise können diese Zeitreihen an Bord von elektrisch angetriebenen Fahrzeugen protokolliert und live in eine Cloud übertragen oder in regelmäßigen Abständen in einer Werkstatt ausgelesen werden. Der wahre Degradationszustand kann insbesondere beispielsweise messtechnisch ermittelt werden, beispielsweise im Labor unter optimalen Bedingungen. Ein Sensor, der direkt den Wert des Degradationszustandes liefert, ist hierfür nicht erforderlich; es genügt beispielsweise eine Messung über den Kapazitätsverlust der Batterie. Beispielsweise können in Testfahrzeugen oder im Rahmen eines simulierten Gebrauchs betriebene Batterien in bestimmten Abständen vermessen werden.

Dieser Aufwand für das Training des HMM muss nur ein einziges Mal investiert werden. Anschließend kann in der Serienfertigung vielfach von diesem HMM profitiert werden.

Somit wird im Rahmen des Verfahrens ein physikalisches Modell bereitgestellt, das Messwerte mindestens der Klemmenspannung, des Entladestroms sowie des Ladezustandes der Batterie auf einen Wert des Degradationszustandes abbildet.

Unter Heranziehung von messtechnischen Unsicherheiten, mit denen die Messung der von dem physikalischen Modell genutzten Messwerte behaftet ist, wird in Abhängigkeit des wahren Degradationszustandes ermittelt, mit welcher Wahrscheinlichkeit bei der messtechnischen Ermittlung der Messwerte und Nutzung des physikalischen Modells welcher Wert des Degradationszustandes beobachtet wird. Hieraus kann die zuvor erwähnte Beobachtungsmatrix gebildet werden.

Unter Heranziehung des Verlaufs des wahren Degradationszustandes wird ermittelt, welcher Wahrscheinlichkeit dieser wahre Degradationszustand wie lange erhalten bleibt, und/oder mit welcher Wahrscheinlichkeit dieser wahre Degradationszustand im nächsten Zeitschritt in welchen schlechteren Degradationszustand übergeht.

Diese Wahrscheinlichkeiten sind vom aktuellen Degradationszustand abhängig, aber auch von der aktuellen Belastung der Batterie mit den bereits genannten und weiteren Stressfaktoren, die der Lebensdauer der Batterie abträglich sind. Man kann also zusätzlich zum wahren Degradationszustand der Batterie auch diese Stressfaktoren als weitere "versteckte" Variable des HMM betrachten. Der aktuelle Zustand des HMM ist dann nicht mehr nur durch den wahren Degradationszustand charakterisiert, sondern auch durch die Stressfaktoren. Von Null verschiedene Übergangswahrscheinlichkeiten können also insbesondere zwischen Zuständen angegeben werden, die durch verschiedene wahre Degradationszustände, aber gleiche Stressfaktoren charakterisiert sind. Es kann also für viele verschiedene Konstellationen von Stressfaktoren jeweils eine Information, wie schnell bei Beibehaltung dieser Stressfaktoren die Degradation weiter voranschreitet, gesammelt und im Laufe des Trainings in der zuvor erwähnten Übergangsmatrix zusammengetragen werden. Die zuvor erwähnte Ermittlung des wahrscheinlichsten Verlaufs des wahren Degradationszustandes liefert dann also nicht nur diesen wahren Degradationszustand selbst, sondern auch die jeweils vorliegenden Stressfaktoren. Es lässt sich dann möglicherweise eingrenzen oder sogar exakt ermitteln, was genau zu der beobachteten Degradation geführt hat, damit etwa Bedienungsfehler künftig vermieden werden können.

Wie zuvor erläutert, macht das physikalische Modell den Degradationszustand zusätzlich von mindestens einer Temperatur in der Batterie abhängig.

Die Verfahren können insbesondere ganz oder teilweise in Software implementiert sein. Daher bezieht sich die Erfindung auch auf ein Computerprogramm mit maschinenlesbaren Anweisungen, die, wenn sie auf einem oder mehreren Computern ausgeführt werden, den oder die Computer dazu veranlassen, eines der beschriebenen Verfahren auszuführen. Ein Downloadprodukt ist ein über ein Datennetzwerk übertragbares, d.h. von einem Benutzer des Datennetzwerks downloadbares, digitales Produkt, das beispielsweise in einem Online-Shop zum sofortigen Download angeboten werden kann.

Weiterhin kann ein Computer mit dem Computerprogramm, mit dem maschinenlesbaren Datenträger bzw. mit dem Downloadprodukt ausgerüstet sein.

Weitere, die Erfindung verbessernde Maßnahmen werden nachstehend gemeinsam mit der Beschreibung der bevorzugten Ausführungsbeispiele der Erfindung anhand von Figuren näher dargestellt.

### Ausführungsbeispiele

Es zeigt:
Figur 1 Ausführungsbeispiel des Verfahrens 100 zum Ermitteln einer Näherung und/oder Prognose 2a der Degradation einer Batterie 1;
Figur 2 Beispielhafter wahrscheinlichster Verlauf 2* der wahren Degradation 2 basierend auf gegebenen messtechnischen Beobachtungen 2b der Degradation;
Figur 3 Ausführungsbeispiel des Verfahrens 200 zum Trainieren eines HMM 4 für den Einsatz in dem Verfahren 100.

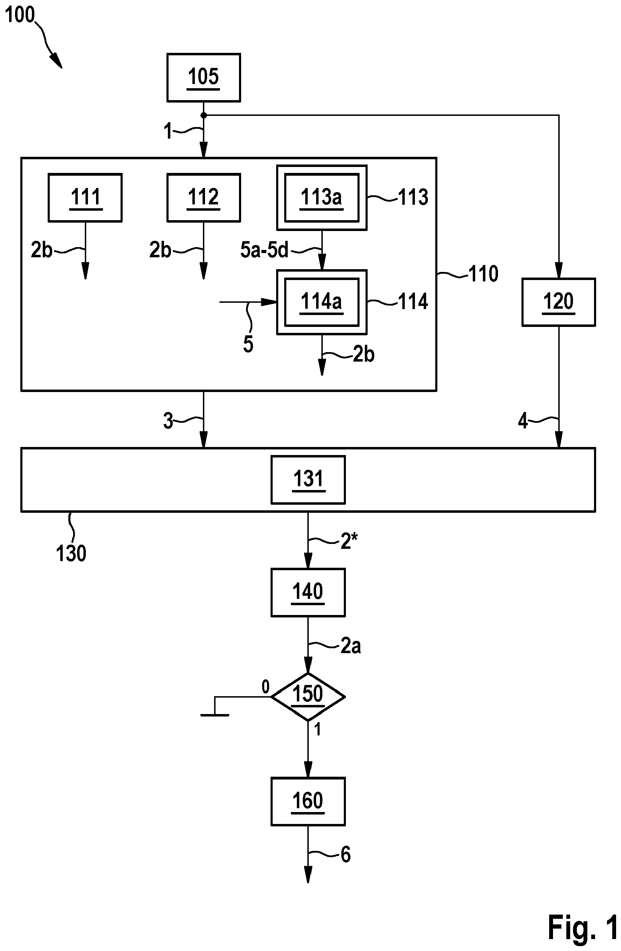

Figur 1 ist ein schematisches Ablaufdiagramm eines Ausführungsbeispiels des Verfahrens 100. In Schritt 105 wird eine Traktionsbatterie eines zumindest teilweise elektrisch angetriebenen Fahrzeugs 1 gewählt.

In Schritt 110 wird eine in vorgegebenen Zeitschritten diskretisierte Zeitreihe 3 von für Zeitpunkte in der Vergangenheit messtechnisch ermittelten Werten 2b des Degradationszustandes bereitgestellt. In Schritt 120 wird ein HMM 4 bereitgestellt, das den wahren Degradationszustand 2 sowie optional auch die auf diesen Degradationszustand wirksamen, nicht direkt messbaren Stressfaktoren in Beziehung setzt zur Wahrscheinlichkeit, dass bestimmte Werte 2b der Degradation beobachtet werden bzw. dass sich der wahre Degradationszustand 2 in bestimmter Weise ändert. Basierend hierauf wird in Schritt 130 der wahrscheinlichste Verlauf 2* des wahren Degradationszustandes 2 in der Vergangenheit ermittelt, der mit der beobachteten Zeitreihe 3 im Einklang steht. Hierbei kann insbesondere gemäß Block 131 ein Viterbi-Algorithmus verwendet werden.

In Schritt 140 wird aus dem wahrscheinlichsten Verlauf 2* die gesuchte Näherung und/oder Prognose 2a ausgewertet. Wenn die Prognose 2a für einen künftigen Zeitpunkt ein vorgegebenes Kriterium 150 erfüllt (Wahrheitswert 1), wird der Zeitraum bis zu diesem künftigen Zeitpunkt in Schritt 160 als verbleibende nutzbare Lebensdauer 6 der Batterie 1 gewertet.

Innerhalb des Kastens 110 sind einige beispielhafte Möglichkeiten angegeben, wie die Zeitreihe 3 der messtechnisch ermittelten Werte 2b der Degradation ermittelt werden kann.

Gemäß Block 111 können die beobachteten Werte 2b des Degradationszustandes anhand einer Ladungsmenge ermittelt werden, die beim Aufladen der Batterie 1 von einer ersten Klemmenspannung auf eine zweite, höhere Klemmenspannung in die Batterie 1 abgegeben wird.

Gemäß Block 112 können die beobachteten Werte 2b des Degradationszustandes anhand einer Zeitdauer ermittelt werden, in der die Klemmenspannung der Batterie 1 unter Belastung mit einer vorgegebenen Last von einem ersten Wert auf einen zweiten, niedrigeren Wert absinkt.

Gemäß Block 113 können während des Entladens der Batterie 1 Zeitreihen der Klemmenspannung 5a, des Entladestroms 5b sowie des Ladezustandes 5c der Batterie 1 erfasst werden. Gemäß Block 113a kann auch eine Temperatur 5d der Batterie 5 erfasst werden.

Gemäß Block 114 können die die beobachteten Werte 2b des Degradationszustandes anhand eines physikalischen Modells 5 des Degradationszustandes aus den Zeitreihen der Messgrößen 5a-5c ermittelt werden. Gemäß Block 114a kann hierbei auch noch die Temperatur 5d berücksichtigt werden.

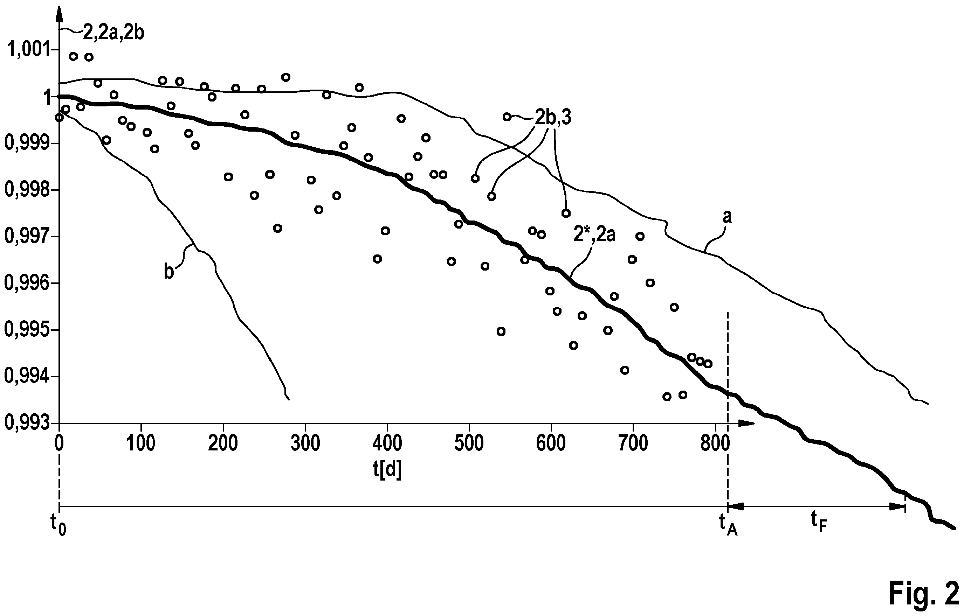

Figur 2 zeigt beispielhaft, wie ausgehend von einer Zeitreihe 3 von messtechnisch beobachteten Werten 2b der Degradation der Batterie 1 der wahrscheinlichste Verlauf 2* der wahren Degradation 2 ermittelt werden kann.

Die beispielhaft eingezeichnete Kurve a repräsentiert einen Zeitverlauf der Degradation, der einer nur langsamen Alterung der Batterie 1 entspricht. Dieser Zeitverlauf steht nur mit wenigen Werten 2b der Zeitreihe 3 im Einklang, ist also weniger plausibel.

Die beispielhaft eingezeichnete Kurve b repräsentiert einen Zeitverlauf der Degradation, der einer sehr schnellen Alterung der Batterie 1 entspricht. Dieser Zeitverlauf steht ebenfalls nur mit wenigen Werten 2b der Zeitreihe 3 im Einklang, ist also ebenfalls weniger plausibel.

Am besten im Einklang mit den vorliegenden beobachteten Werten 2b steht der auf Grund des HMM 4 ermittelte wahrscheinlichste Verlauf 2* der wahren Degradation 2. Dieser Verlauf 2* liefert nicht nur für jede vergangene Zeit von der Inbetriebnahme der Batterie 1 bei der Zeit t₀ bis zum aktuellen Zeitpunkt t_{A} eine Näherung 2a für die wahre Degradation 2. Vielmehr geht diese Näherung 2a für zukünftige Zeiten t_{F} jenseits der aktuellen Zeit t_{A} nahtlos in eine Prognose über.

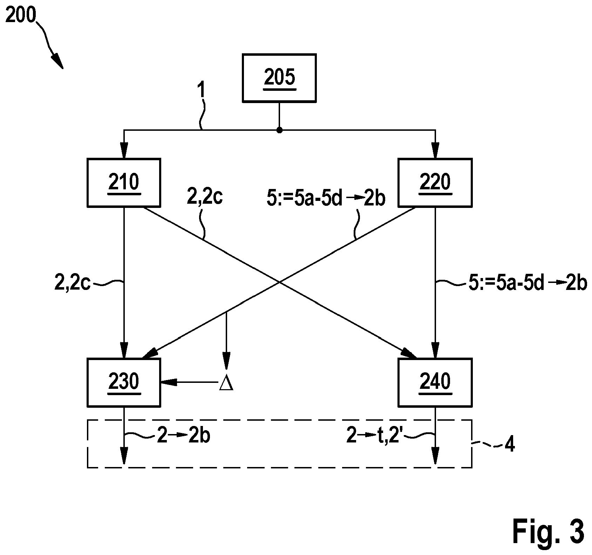

Figur 3 zeigt ein Ausführungsbeispiel des Verfahrens 200 zum Trainieren des HMM 4. Analog zu Schritt 105 in Figur 1 wird in Schritt 205 eine Traktionsbatterie eines Fahrzeugs als Batterie 1 gewählt.

In Schritt 210 werden für eine Vielzahl derartiger Batterien Zeitreihen 2c des wahren Degradationszustandes 2 bereitgestellt. In Schritt 220 wird ein physikalisches Modell 5 bereitgestellt, das Messwerte mindestens der Klemmenspannung 5a, des Entladestroms 5b sowie des Ladezustandes 5c der Batterie 1 auf einen Wert 2b des Degradationszustandes abbildet.

In Schritt 230 wird unter Heranziehung von messtechnischen Unsicherheiten Δ, mit denen die Messung dieser Messwerte 5a-5c behaftet ist, in Abhängigkeit des wahren Degradationszustandes 2 ermittelt, mit welcher Wahrscheinlichkeit bei der messtechnischen Ermittlung der Messwerte und Nutzung des physikalischen Modells welcher Wert 2b des Degradationszustandes beobachtet wird.

In Schritt 240 wird unter Heranziehung des Verlaufs des wahren Degradationszustandes 2 ermittelt, mit welcher Wahrscheinlichkeit dieser wahre Degradationszustand 2 für welche Zeit t wie lange erhalten bleibt, und/oder mit welcher Wahrscheinlichkeit dieser wahre Degradationszustand im nächsten Zeitschritt in welchen schlechteren Degradationszustand 2' übergeht.

Die in den Schritten 230 und 240 ermittelten Informationen charakterisieren das HMM 4.

## Patentansprüche

1. Verfahren (100) zur Ermittlung einer Näherung und/oder Prognose (2a) für den wahren Degradationszustand (2) einer wiederaufladbaren Batterie (1) mit den Schritten:
• es wird eine in vorgegebenen Zeitschritten diskretisierte Zeitreihe (3) von für Zeitpunkte in der Vergangenheit messtechnisch ermittelten Werten (2b) des Degradationszustandes bereitgestellt (110),
∘ wobei während des Entladens der Batterie (1) Zeitreihen der Klemmenspannung (5a), des Entladestroms (5b) sowie des Ladezustandes (5c) der Batterie (1) erfasst werden (113) und wobei die beobachteten Werte (2b) des Degradationszustandes anhand eines physikalischen Modells (5) des Degradationszustandes aus diesen Zeitreihen ermittelt werden (114),
∘ wobei zusätzlich eine Zeitreihe mindestens einer Temperatur (5d) in der Batterie (1) während des Entladens erfasst wird (113a) und wobei diese Temperatur in dem physikalischen Modell (5) berücksichtigt wird (114a);
• es wird ein trainiertes Hidden Markov-Modell, HMM (4), bereitgestellt (120), das in Abhängigkeit des wahren Degradationszustandes (2) angibt,
∘ mit welcher Wahrscheinlichkeit bei der messtechnischen Ermittlung welcher Wert (2b) des Degradationszustandes beobachtet wird und
∘ mit welcher Wahrscheinlichkeit dieser wahre Degradationszustand (2) wie lange erhalten bleibt, und/oder mit welcher Wahrscheinlichkeit dieser wahre Degradationszustand im nächsten Zeitschritt in welchen schlechteren Degradationszustand (2') übergeht;
• aus der beobachteten Zeitreihe (3) und dem HMM (4) wird der wahrscheinlichste Verlauf (2*) des wahren Degradationszustandes (2) in der Vergangenheit ermittelt (130), der mit der beobachteten Zeitreihe (3) im Einklang steht;
• aus dem wahrscheinlichsten Verlauf (2*) wird die gesuchte Näherung und/oder Prognose (2a) ausgewertet (140).

2. Verfahren (100) nach Anspruch 1, wobei die beobachteten Werte (2b) des Degradationszustandes anhand einer Ladungsmenge ermittelt werden (111), die beim Aufladen der Batterie (1) von einer ersten Klemmenspannung auf eine zweite, höhere Klemmenspannung in die Batterie (1) abgegeben wird.

3. Verfahren (100) nach einem der Ansprüche 1 bis 2, wobei die beobachteten Werte (2b) des Degradationszustandes anhand einer Zeitdauer ermittelt werden (112), in der die Klemmenspannung der Batterie (1) unter Belastung mit einer vorgegebenen Last von einem ersten Wert auf einen zweiten, niedrigeren Wert absinkt.

4. Verfahren (100) nach einem der Ansprüche 1 bis 3, wobei der wahrscheinlichste Verlauf (2*) des wahren Degradationszustandes (2) mit einem Viterbi-Algorithmus ermittelt wird (131).

5. Verfahren (100) nach einem der Ansprüche 1 bis 4, wobei in Antwort darauf, dass eine für einen künftigen Zeitpunkt ermittelte Prognose (2a) für den wahren Degradationszustand (2) ein vorgegebenes Kriterium (150) erfüllt, der Zeitraum bis zu diesem künftigen Zeitpunkt als verbleibende nutzbare Lebensdauer (6) der Batterie (1) gewertet wird (160).

6. Verfahren (200) zum Trainieren eines Hidden-Markov-Modells, HMM (4), für den Einsatz in dem Verfahren (100) mit den Schritten:
• Zeitreihen (2c) des Verlaufs des wahren Degradationszustandes (2) einer Vielzahl von Batterien (1) während ihres Gebrauchs werden bereitgestellt (210);
• es wird ein physikalisches Modell (5) bereitgestellt (220), das Messwerte mindestens der Klemmenspannung (5a), des Entladestroms (5b) sowie des Ladezustandes (5c) der Batterie (1) auf einen Wert (2b) des Degradationszustandes abbildet, wobei das physikalische Modell (5) den Degradationszustand (2b) zusätzlich von mindestens einer Temperatur (5d) in der Batterie (1) abhängig macht;
• unter Heranziehung von messtechnischen Unsicherheiten (Δ), mit denen die Messung dieser Messwerte (5a-5c) behaftet ist, wird in Abhängigkeit des wahren Degradationszustandes (2) ermittelt (230), mit welcher Wahrscheinlichkeit bei der messtechnischen Ermittlung der Messwerte und Nutzung des physikalischen Modells welcher Wert (2b) des Degradationszustandes beobachtet wird;
• unter Heranziehung des Verlaufs des wahren Degradationszustandes (2) wird ermittelt (240), mit welcher Wahrscheinlichkeit dieser wahre Degradationszustand (2) wie lange erhalten bleibt, und/oder mit welcher Wahrscheinlichkeit dieser wahre Degradationszustand im nächsten Zeitschritt in welchen schlechteren Degradationszustand (2') übergeht.

7. Verfahren (100, 200) nach einem der Ansprüche 1 bis 6, wobei eine Traktionsbatterie eines zumindest teilweise elektrisch angetriebenen Fahrzeugs als Batterie (1) gewählt wird (105, 205).

8. Computerprogramm, enthaltend maschinenlesbare Anweisungen, die, wenn sie auf einem oder mehreren Computern ausgeführt werden, den oder die Computer dazu veranlassen, ein Verfahren (100, 200) nach einem der Ansprüche 1 bis 7 auszuführen.

9. Maschinenlesbarer Datenträger mit dem Computerprogramm nach Anspruch 8.

10. Computer, ausgerüstet mit dem Computerprogramm nach Anspruch 8, und/oder mit dem maschinenlesbaren Datenträger nach Anspruch 9.

## Claims

1. Method (100) for determining an approximation and/or prediction (2a) for the true degradation state (2) of a rechargeable battery (1), having the following steps:
• a time series (3), discretized into predefined time steps, of values (2b) of the degradation state, which are determined using metrology for points in time in the past, is provided (110),
∘ wherein, during the discharging of the battery (1), time series of the terminal voltage (5a), the discharge current (5b) and the state of charge (5c) of the battery (1) are recorded (113), and wherein the observed values (2b) of the degradation state are determined (114) from these time series on the basis of a physical model (5) of the degradation state,
∘ wherein a time series of at least one temperature (5d) in the battery (1) is additionally recorded (113a) during discharging, and wherein this temperature is taken into account (114a) in the physical model (5);
• a trained hidden Markov model, HMM (4), is provided (120) and, on the basis of the true degradation state (2), indicates
with which probability which value (2b) of the degradation state is observed during the metrological determination, and
∘ with which probability this true degradation state (2) is maintained for how long and/or with which probability this true degradation state changes to which worse degradation state (2') in the next time step;
• the observed time series (3) and the HMM (4) are used to determine (130) the most probable progression (2*) of the true degradation state (2) in the past that is in accordance with the observed time series (3);
• the most probable progression (2*) is used to evaluate (140) the approximation and/or prediction (2a) sought.

2. Method (100) according to Claim 1, wherein the observed values (2b) of the degradation state are determined (111) on the basis of an amount of charge which is delivered into the battery (1) when charging the battery (1) from a first terminal voltage to a second, higher terminal voltage.

3. Method (100) according to one of Claims 1 to 2, wherein the observed values (2b) of the degradation state are determined (112) on the basis of a period of time in which the terminal voltage of the battery (1) falls from a first value to a second, lower value when loaded with a predefined load.

4. Method (100) according to one of Claims 1 to 3, wherein the most probable progression (2*) of the true degradation state (2) is determined (131) using a Viterbi algorithm.

5. Method (100) according to one of Claims 1 to 4, wherein, in response to a prediction (2a) determined for the true degradation state (2) for a future point in time satisfying a predefined criterion (150), the period of time up to this future point in time is deemed (160) to be the remaining usable service life (6) of the battery (1) .

6. Method (200) for training a hidden Markov model, HMM (4), for use in the method (100), having the following steps:
• time series (2c) of the progression of the true degradation state (2) of a multiplicity of batteries (1) during their use are provided (210);
• a physical model (5) is provided (220) and maps measured values of at least the terminal voltage (5a), the discharge current (5b) and the state of charge (5c) of the battery (1) to a value (2b) of the degradation state, wherein the physical model (5) additionally makes the degradation state (2b) dependent on at least one temperature (5d) in the battery (1);
• metrological uncertainties (Δ), with which the measurement of these measured values (5a-5c) is afflicted, are used to determine (230), on the basis of the true degradation state (2), with which probability which value (2b) of the degradation state is observed during the metrological determination of the measured values and use of the physical model;
• the progression of the true degradation state (2) is used to determine (240) with which probability this true degradation state (2) is maintained for how long and/or with which probability this true degradation states changes to which worse degradation state (2') in the next time step.

7. Method (100, 200) according to one of Claims 1 to 6, wherein a traction battery of an at least partially electrically driven vehicle is selected (105, 205) as the battery (1).

8. Computer program containing machine-readable instructions which, when executed on one or more computers, cause the computer or computers to carry out a method (100, 200) according to any of Claims 1 to 7.

9. Machine-readable data carrier containing the computer program according to Claim 8.

10. Computer equipped with the computer program according to Claim 8 and/or with the machine-readable data carrier according to Claim 9.

## Revendications

1. Procédé (100) de détermination d'une approximation et/ou d'une prévision (2a) pour l'état de dégradation (2) vrai d'une batterie rechargeable (1), comprenant les étapes :
• une série chronologique (3), discrétisée en des pas de temps prédéfinis, de valeurs (2b) de l'état de dégradation, déterminées de manière métrologique pour des points de temps dans le passé est fournie (110),
∘ des séries chronologiques de la tension aux bornes (5a), du courant de décharge (5b) ainsi que de l'état de charge (5c) de la batterie (1) étant acquises (113) pendant la décharge de la batterie (1), et les valeurs (2b) observées de l'état de dégradation étant déterminées (114) à l'aide d'un modèle physique (5) de l'état de dégradation à partir de ces séries chronologiques,
∘ une série chronologique d'au moins une température (5d) dans la batterie (1) étant en plus acquise (113a) pendant la décharge et cette température étant prise en compte (114a) dans le modèle physique (5) ;
• un modèle de Markov caché, MMC (4), entraîné est fourni (120), lequel indique, en fonction de l'état de dégradation (2) vrai,
∘ la probabilité avec laquelle, lors de la détermination métrologique, quelle valeur (2b) de l'état de dégradation est observée et
∘ la probabilité avec laquelle cet état de dégradation (2) vrai se maintient et pendant combien de temps, et/ou la probabilité avec laquelle cet état de dégradation vrai passe dans quel état de dégradation pire (2') dans le pas de temps suivant ;
• l'évolution la plus probable (2*) de l'état de dégradation (2) vrai dans le passé, qui est en accord avec la série chronologique (3) observée, est déterminée (130) à partir de la série chronologique (3) observée et du MMC (4) ;
• l'approximation et/ou la prévision (2a) recherchée est évaluée (140) à partir de l'évolution la plus probable (2*).

2. Procédé (100) selon la revendication 1, les valeurs observées (2b) de l'état de dégradation étant déterminées (111) à l'aide d'une quantité de charge qui est délivrée dans la batterie (1) lors de la charge de la batterie (1) d'une première tension aux bornes à une deuxième tension aux bornes, plus élevée.

3. Procédé (100) selon l'une des revendications 1 à 2, les valeurs observées (2b) de l'état de dégradation étant déterminées (112) à l'aide d'une durée pendant laquelle la tension aux bornes de la batterie (1) chargée avec une charge prédéfinie passe d'une première valeur à une deuxième valeur, plus faible.

4. Procédé (100) selon l'une des revendications 1 à 3, l'évolution la plus probable (2*) de l'état de dégradation (2) vrai étant déterminée (131) avec un algorithme de Viterbi.

5. Procédé (100) selon l'une des revendications 1 à 4, en réponse au fait qu'une prévision (2a) de l'état de dégradation (2) vrai déterminée pour un instant futur satisfait à un critère prédéterminé (150), la période allant jusqu'à cet instant futur étant évaluée (160) comme étant la durée de vie utile restante (6) de la batterie (1).

6. Procédé (200) d'entraînement d'un modèle de Markov caché, MMC (4), pour l'utilisation dans le procédé (100), comprenant les étapes :
• des séries chronologiques (2c) de l'évolution de l'état de dégradation (2) vrai d'une pluralité de batteries (1) pendant leur utilisation sont fournies (210) ;
• un modèle physique (5) fourni (220), lequel représente des valeurs mesurées au moins de la tension aux bornes (5a), du courant de décharge (5b) ainsi que de l'état de charge (5c) de la batterie (1) sur une valeur (2b) de l'état de dégradation, le modèle physique (5) rendant en plus l'état de dégradation (2b) dépendant d'au moins une température (5d) dans la batterie (1) ;
• la probabilité avec laquelle quelle valeur (2b) de l'état de dégradation est observée lors de la détermination métrologique des valeurs mesurées et de l'utilisation du modèle physique est déterminée (230) en fonction de l'état de dégradation (2) vrai en utilisant les incertitudes métrologiques (Δ) dont est entachée la mesure de ces valeurs mesurées (5a-5c) ;
• la probabilité avec laquelle cet état de dégradation (2) vrai se maintient et pendant combien de temps, et/ou la probabilité avec laquelle cet état de dégradation vrai passe dans quel état de dégradation pire (2') dans le pas de temps suivant est déterminée (240) en utilisant l'évolution de l'état de dégradation (2) vrai.

7. Procédé (100, 200) selon l'une des revendications 1 à 6, une batterie (1) choisie (105, 205) étant une batterie de traction d'un véhicule à propulsion au moins partiellement électrique.

8. Programme informatique contenant des instructions lisibles par machine qui, lorsqu'elles sont exécutées sur un ou plusieurs ordinateurs, amènent l'ordinateur ou les ordinateurs à mettre en œuvre un procédé (100, 200) selon l'une des revendications 1 à 7.

9. Support de données lisible par machine, comprenant le programme informatique selon la revendication 8.

10. Ordinateur, équipé du programme informatique selon la revendication 8 et/ou du support de données lisible par machine selon la revendication 9.
